# EUROPÄISCHE PATENTSCHRIFT

(11) **EP 2 993 258 B1**
(45) Veröffentlichungstag und Bekanntmachung des Hinweises auf die Patenterteilung: **05.10.2016**
(21) Anmeldenummer: 15181661.8
(22) Anmeldetag: 20.08.2015
(51) Int. Cl.: C30B 13/28, C30B 29/06

(54) **VERFAHREN ZUM ABSTÜTZEN EINES WACHSENDEN EINKRISTALLS WÄHREND DES KRISTALLISIERENS DES EINKRISTALLS GEMÄSS DEM FZ-VERFAHREN**
METHOD OF SUPPORTING A GROWING SINGLE CRYSTAL DURING CRYSTALLIZATION OF THE SINGLE CRYSTAL ACCORDING TO THE FZ METHOD
PROCEDE DE SOUTIEN D'UN MONOCRISTAL CROISSANT PENDANT LA CRISTALLISATION DU MONOCRISTAL SELON LE PROCEDE FZ

(30) Priorität: 03.09.2014 DE 102014217605
(43) Veröffentlichungstag der Anmeldung: 09.03.2016
(73) Patentinhaber: Siltronic AG, 81737 München (DE)
(72) Erfinder: Niederer, Kurt, 84307 Eggenfelden (DE); Terörde, Helmut, 5121 St. Radegund (AT); Berger, Josef, 84571 Reischach (DE); Meisterernst, Götz, 84453 Mühldorf (DE); Mümmler, Frank, 84547 Emmerting (DE); Zitzelsberger, Simon, 84524 Neuötting (DE)
(74) Vertreter: Staudacher, Wolfgang

(56) Entgegenhaltungen:
- EP-A1- 0 288 639
- DE-A1- 2 652 199
- JP-A- H05 194 074
- US-A- 3 996 096

## Beschreibung

Gegenstand der Erfindung ist ein Verfahren zum Abstützen eines wachsenden Einkristalls im Bereich eines konusförmigen Abschnitts des Einkristalls durch einen Stützkörper während des Kristallisierens des Einkristalls gemäß dem FZ-Verfahren.

Während der Herstellung eines Einkristalls nach dem FZ-Verfahren (floating zone method), das auch Zonenzieh-Verfahren genannt wird, wächst ein Einkristall aufrecht stehend an einer Phasengrenze, die am oberen Ende des wachsenden Einkristalls zwischen einer Schmelze und dem wachsenden Einkristall besteht. Durch Absenken des Einkristalls kristallisiert Material der Schmelze unter Vergrößerung des Volumens des Einkristalls. Der dadurch entstehende Verlust an Schmelze wird ausgeglichen, indem ein fester Vorrat, beispielsweise ein Vorratsstab, (feed rod) nach und nach geschmolzen und der Schmelze zugeführt wird. Es sind auch Verfahren bekannt, bei denen an Stelle eines Vorratstabs körniges Material geschmolzen wird.

Um den wachsenden Einkristall zu erhalten, wird ein vergleichsweise dünner Impfkristall mit geschmolzenem Material des Vorrats in Kontakt gebracht. Zunächst wird ein dünner Hals erzeugt, um ein versetzungsfreies Kristallwachstum zu erreichen. Auf dem dünnen Hals wächst der Einkristall erst zu einem konusförmigen Abschnitt mit ansteigendem Durchmesser und später zu einem zylindrischen Abschnitt mit gleichbleibendem Durchmesser. Um für ein möglichst gleichmäßiges Kristallwachstum und für eine möglichst gleichmäßige Verteilung von Dotierstoffen zu sorgen, wird der wachsende Einkristall um seine Längsachse gedreht. Wird der Drehsinn währenddessen nach einem bestimmten Muster in Abständen umgekehrt, spricht man von einer Wechseldrehung.

Die Oberflächenspannung hält die Schmelze am oberen Ende des wachsenden Einkristalls in Position. Entsprechend empfindlich reagiert die Schmelze auf Störungen, insbesondere auf Schwingungen des wachsenden Einkristalls. Schwingungen, die die Schmelze zum Überlaufen bringen und/oder den Abbruch des einkristallinen Kristallwachstums zur Folge haben, müssen unbedingt vermieden werden. Die Gefahr, dass es dazu kommt, steigt mit dem Durchmesser und dem Gewicht des herzustellenden Einkristalls.

Schon früh in der Entwicklung des FZ-Verfahrens wurden Maßnahmen vorgeschlagen, die den wachsenden Einkristall vor solchen Störungen schützen sollen. In der DE 2652199 ist ein Verfahren beschrieben, das vorsieht, ein zylindrisches Rohrstück aus Glas als Stützkörper an den konusförmigen Abschnitt des wachsenden Einkristalls anzulegen. Das Verfahren ist zur Herstellung von mittlerweile üblichen Einkristallen mit deutlich höherem Gewicht nicht mehr ausreichend. Der Glaskörper ist der mechanischen Belastung nicht mehr vollumfänglich gewachsen und kann wegen der auf ihn einwirkenden Stützkräfte auseinanderbrechen.

In der DE 2455173 wird vorgeschlagen, zum Abstützen des Endes eines Kristallstabs eine mehrteilige Trichterhülse zu verwenden, die mit Glaskugeln als Stabilisierungsmittel gefüllt ist. Eine solche Vorrichtung erfüllt die Anforderungen auch nicht mehr. Eine ausreichende Verspannung mit dem wachsenden Einkristall kann mit dieser nicht herbeigeführt werden. Eine solche Verspannung ist aber notwendig, damit die bei einer Wechseldrehung auftretenden Kräfte aufgenommen werden können.

Gemäß der EP 0 288 639 A1 wird ein Ring aus einem harten keramischem Material oder aus einem harten Metall zum Abstützen des Einkristalls verwendet.

Die Erfinder der vorliegenden Erfindung haben festgestellt, dass auch ein harter Ring Nachteile hat. Auf der Oberfläche eines wachsenden Einkristalls befinden sich Ziehkanten (crystal ridges). Ziehkanten sind sich in Wachstumsrichtung des Einkristalls erstreckende Wülste, die von der Mantelfläche des konusförmigen Abschnitts beziehungsweise von der Mantelfläche des zylindrischen Abschnitts des wachsenden Einkristalls wegstehen. Beim Anlegen des harten Rings an den wachsenden Einkristall werden Auflagekräfte besonders über die wegstehenden Ziehkanten auf den harten Ring übertragen. Dabei kann auf die Ziehkanten ein solcher Druck ausgeübt werden, dass sie an den betroffenen Stellen kollabieren. Die dem Kollabieren folgende Erschütterung des wachsenden Einkristalls stellt eine Störung dar, die die Schmelze in Schwingungen versetzt und deren Überlaufen verursachen kann.

Es ist daher Aufgabe der vorliegenden Erfindung, ein Verfahren zum Abstützen eines wachsenden Einkristalls vorzuschlagen, das auch den Anforderungen gewachsen ist, die erfüllt werden müssen, um große und schwere Einkristalle mit hoher Ausbeute herstellen zu können.

Gelöst wird die Aufgabe durch ein Verfahren zum Abstützen eines wachsenden Einkristalls im Bereich eines konusförmigen Abschnitts des Einkristalls durch einen Stützkörper während des Kristallisierens des Einkristalls gemäß dem FZ-Verfahren, umfassend
das Pressen eines Stützkörpers gegen den konusförmigen Abschnitt des wachsenden Einkristalls, von dessen Mantelfläche Ziehkanten wegstehen, bei einer Temperatur, bei der ein erstes Material des Stützkörpers weich wird, und das fortgesetzte Pressen des Stützkörpers gegen den konusförmigen Abschnitt des Einkristalls solange, bis das erste Material und ein zweites Material des Stützkörpers, das bei der genannten Temperatur fest bleibt, den konusförmigen Abschnitt des wachsenden Einkristalls berühren.

Auf diese Weise werden Auflagekräfte über eine vergleichsweise große Fläche verteilt auf den Stützkörper zum Abstützen des wachsenden Einkristalls übertragen. Zu einem Kollabieren von Ziehkanten und damit ausgelösten Nachfolgeschäden kommt es nicht mehr. Gleichzeitig hält die Anordnung aus wachsendem Einkristall und Stützkörper problemlos Kräften Stand, die in Folge einer Wechseldrehung des wachsenden Einkristalls auf sie einwirkt.

Das erste Material des Stützkörpers ist vorzugsweise Glas, besonders bevorzugt Borsilikatglas. Das zweite Material des Stützkörpers ist vorzugsweise ein Metall, besonders bevorzugt Stahl, oder ein keramisches Material, besonders bevorzugt Siliziumnitrid.

Gemäß einer besonders bevorzugten Ausführungsform der Erfindung umfasst der Stützkörper einen äußeren zylindrischen Ring bestehend aus dem zweiten Material und einen inneren zylindrischen Ring bestehend aus dem ersten Material.

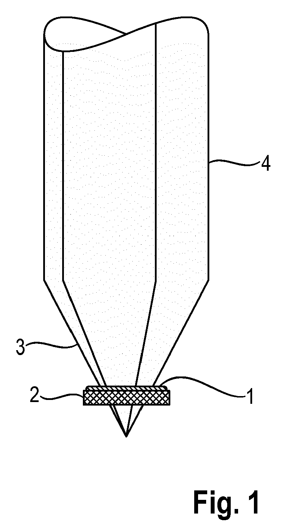

Fig.1 zeigt in Seitenansicht eine erfindungsgemäße Anordnung dieses Stützkörpers und eines Einkristalls. Der innere zylindrische Ring 1 ist in den äußeren zylindrischen Ring 2 eingebettet, so dass die äußere Mantelfläche des inneren zylindrischen Rings an die innere Mantelfläche des äußeren zylindrischen Rings angrenzt. Der Stützkörper wird gegen den konusförmigen Abschnitt 3 des wachsenden Einkristalls 4 gepresst, bis ein Zwischenraum zwischen einer inneren Mantelfläche des äußeren Rings und dem wachsenden Einkristall vom ersten Material eingenommen wird und Ziehkanten des Einkristalls Kontakt zur inneren Mantelfläche des äußeren Rings haben.

Besteht der äußere zylindrische Ring aus Metall, ist das Metall vorzugsweise Stahl oder ein Metall, dessen Härte nicht geringer ist, als die Härte von Stahl. Besteht der äußere zylindrische Ring aus keramischem Material, ist das Material vorzugsweise Siliziumnitrid oder ein keramisches Material, dessen Härte nicht geringer ist, als die Härte von Siliziumnitrid. Das Glas, aus dem der innere zylindrische Ring besteht, ist vorzugsweise ein anorganisches oxidisches Glas, besonders bevorzugt Borsilikatglas, insbesondere von SCHOTT unter der eingetragenen Marke DURAN^{®} vertriebenes Borosilicatglas 3.3. Die Transformations-Temperatur des Glases ist vorzugsweise nicht mehr als 520 - 550 °C.

Die Dicke des Mantels zwischen der inneren und der äußeren Mantelfläche des inneren zylindrischen Rings beträgt vorzugsweise nicht weniger als 2 mm und nicht mehr als 10 mm. Die Höhe des Mantels des inneren zylindrischen Rings beträgt vorzugsweise nicht weniger als 2 mm und nicht mehr als 10 mm.

Die Dicke des Mantels zwischen der inneren und der äußeren Mantelfläche des äußeren zylindrischen Rings beträgt vorzugsweise nicht weniger als 2 mm und nicht mehr als 10 mm. Die Höhe des Mantels des äußeren zylindrischen Rings beträgt vorzugsweise nicht weniger als 2 mm und nicht mehr als 10 mm.

Der Stützkörper wird gegen den konusförmigen Abschnitt des wachsenden Einkristalls gepresst und zwar zu einem Zeitpunkt, zu dem der konusförmige Abschnitt eine Temperatur hat, bei der der zylindrische Ring aus Glas weich und viskos wird. Dabei drücken Ziehkanten durch das Glas, bis sie mit der inneren Mantelfläche des äußeren Rings in Kontakt kommen, und Glas füllt den Zwischenraum zwischen dem wachsenden Einkristall und der inneren Mantelfläche des äußeren Rings aus. Im weiteren Verlauf des Kristallwachstums nimmt die Temperatur des konusförmigen Abschnitts mit zunehmendem Abstand des konusförmigen Abschnitts des Einkristalls zur Phasengrenze ab, so dass das Glas erstarrt.

In dieser Situation werden Auflagekräfte über eine vergleichsweise große Fläche verteilt auf den Stützkörper zum Abstützen des wachsenden Einkristalls übertragen. Zu einem Kollabieren von Ziehkanten und damit ausgelösten Nachfolgeschäden kommt es nicht mehr. Gleichzeitig hält diese Anordnung aus wachsendem Einkristall und Stützkörper zum Abstützen des wachsenden Einkristalls problemlos Kräften Stand, die in Folge einer Wechseldrehung des wachsenden Einkristalls auf sie einwirkt.

Es wird bevorzugt, den Stützkörper schwimmend auf einer Unterlage zu lagern, wenn er gegen den konusförmigen Abschnitt des wachsenden Einkristalls gepresst wird. Durchmesser-Variationen können dadurch besser ausgeglichen werden. Eine solche Lagerung ist in der DE 2652199 beschrieben. Zum Pressen des Stützkörpers gegen den konusförmigen Abschnitt kann beispielsweise eine Vorrichtung eingesetzt werden, die analog der Funktionsweise einer Vorrichtung arbeitet, wie sie aus der DE2652199 oder der EP 0 288 639 A1 hervorgeht.

Das erfindungsgemäße Verfahren wird vorzugsweise zum Abstützen von wachsenden Einkristallen aus Halbleitermaterial eingesetzt, besonders bevorzugt zum Abstützen von wachsenden Einkristallen aus Silizium. Der Durchmesser der Einkristalle kann im zylindrischen Abschnitt 200 mm oder größer sein und das Gewicht des gewachsenen Einkristalls kann 20 kg oder größer sein.

## Patentansprüche

1. Verfahren zum Abstützen eines wachsenden Einkristalls im Bereich eines konusförmigen Abschnitts des Einkristalls durch einen Stützkörper während des Kristallisierens des Einkristalls gemäß dem FZ-Verfahren, umfassend das Pressen eines Stützkörpers gegen den konusförmigen Abschnitt des wachsenden Einkristalls, von dessen Mantelfläche Ziehkanten wegstehen, bei einer Temperatur, bei der ein erstes Material des Stützkörpers weich wird, und das fortgesetzte Pressen des Stützkörpers gegen den konusförmigen Abschnitt des wachsenden Einkristalls solange, bis das erste Material und ein zweites Material des Stützkörpers, das bei der genannten Temperatur fest bleibt, den konusförmigen Abschnitt des wachsenden Einkristalls berühren.

2. Verfahren nach Anspruch 1, **dadurch gekennzeichnet, dass** das erste Material Glas ist.

3. Verfahren nach Anspruch 1 oder Anspruch 2, **dadurch gekennzeichnet, dass** das erste Material Borsilikatglas ist.

4. Verfahren nach einem der Ansprüche 1 bis 3, **dadurch gekennzeichnet, dass** das zweite Material ein Metall oder ein keramisches Material ist.

5. Verfahren nach einem der Ansprüche 1 bis 4, **dadurch gekennzeichnet, dass** das zweite Material Stahl oder Siliziumnitrid ist.

6. Verfahren nach einem der Ansprüche 1 bis 5, wobei der Stützkörper einen äußeren zylindrischen Ring aus dem zweiten Material und einen inneren zylindrischen Ring aus dem ersten Material umfasst, und gegen den konusförmigen Abschnitt des wachsenden Einkristalls gepresst wird, bis ein Zwischenraum zwischen einer inneren Mantelfläche des äußeren Rings und dem wachsenden Einkristall vom ersten Material eingenommen wird und Ziehkanten des Einkristalls Kontakt zur inneren Mantelfläche des äußeren Rings haben.

## Claims

1. Method of supporting a growing single crystal in the region of a conical section of the single crystal via a supporting body during crystallization of the single crystal according to the FZ method, comprising pressing a supporting body against the conical section of the growing single crystal, from the lateral surface of which crystal ridges protrude, at a temperature at which a first material of the supporting body becomes soft and continued pressing of the supporting body against the conical section of the growing single crystal until the first material and a second material of the supporting body that remains hard at the cited temperature touch the conical section of the growing single crystal.

2. Method according to Claim 1, **characterized in that** the first material is glass.

3. Method according to Claim 1 or Claim 2, **characterized in that** the first material is borosilicate glass.

4. Method according to any of Claims 1 to 3, **characterized in that** the second material is a metal or a ceramic material.

5. Method according to any of Claims 1 to 4, **characterized in that** the second material is steel or silicon nitride.

6. Method according to any of Claims 1 to 5, **characterized in that** the supporting body comprises an outer cylindrical ring of the second material and an inner cylindrical ring of the first material and is pressed against the conical section of the growing single crystal until an interspace between an inner lateral surface of the outer ring and the growing single crystal is occupied by the first material and crystal ridges of the single crystal contact the inner lateral surface of the outer ring.

## Revendications

1. Procédé pour le soutien d'un monocristal en croissance dans la zone d'une partie conique du monocristal, par un corps de soutien pendant la cristallisation du monocristal selon le procédé FZ, comprenant le fait de presser un corps de soutien contre la partie conique du monocristal en croissance, de la surface latérale duquel s'étendent les bords de tirage, à une température à laquelle un premier matériau du corps de soutien s'amollit, et de continuer à presser le corps de soutien contre la partie conique du monocristal en croissance, jusqu'à ce que le premier matériau et un second matériau du corps de soutien, qui reste solide à ladite température, entrent en contact avec la partie conique du monocristal en croissance.

2. Procédé selon la revendication 1, **caractérisé en ce que** le premier matériau est du verre.

3. Procédé selon la revendication 1 ou la revendication 2, **caractérisé en ce que** le premier matériau est du verre borosilicate.

4. Procédé selon l'une quelconque des revendications 1 à 3, **caractérisé en ce que** le second matériau est un métal ou un matériau céramique.

5. Procédé selon l'une quelconque des revendications 1 à 4, **caractérisé en ce que** le second matériau est l'acier ou le nitrure de silicium.

6. Procédé selon l'une quelconque des revendications 1 à 5, dans lequel le corps de soutien comprend un anneau cylindrique externe à base du second matériau et un anneau cylindrique interne à base du premier matériau, et est pressé contre la partie conique du monocristal en croissance, jusqu'à ce qu'un espace intermédiaire entre une surface latérale interne de l'anneau externe et le monocristal en croissance soit occupée par le premier matériau et que les bords de tirage du monocristal soient en contact avec la surface latérale interne de l'anneau externe.
